# EUROPÄISCHE PATENTSCHRIFT

(11) **EP 1 340 271 B1**
(45) Veröffentlichungstag und Bekanntmachung des Hinweises auf die Patenterteilung: **20.02.2013**
(21) Anmeldenummer: 01989560.6
(22) Anmeldetag: 03.12.2001
(51) Int. Cl.: H01L 51/30, C08G 61/02, H01L 51/50

(54) **BREITBANDIG LICHTEMITTIERENDE POLYMERE DIODEN (PLED)**
BROADBAND LIGHT-EMITTING POLYMERIC DIODES (PLED)
DIODES POLYMERES ELECTROLIMINESCENTES (PLED) A BANDE LARGE

(30) Priorität: 01.12.2000 DE 10059810
(43) Veröffentlichungstag der Anmeldung: 03.09.2003
(73) Patentinhaber: Fraunhofer-Gesellschaft zur Förderung der angewandten Forschung e.V., 80686 München (DE)
(72) Erfinder: JANIETZ, Silvia, 14532 Stahnsdorf (DE); WEDEL, Armin, 14513 Teltow (DE)
(74) Vertreter: Albrecht, Thomas
(86) Internationale Anmeldenummer: PCT/EP2001/014093
(87) Internationale Veröffentlichungsnummer: WO 2002/045185

(56) Entgegenhaltungen:
- WO-A-00/14144
- US-A- 5 679 757
- US-A- 6 127 693

## Beschreibung

Die Erfindung betrifft neue polymere, breitbandig lichtemittierende Dioden, im weiteren als PLED bezeichnet, die weißes Licht aufgrund eines breiten Spektrums emittieren, sowie ein Verfahren zu ihrer Herstellung.

Tang und van Slyke waren die ersten, die LEDs auf Basis von organischen Materialien vorstellten (C.W. Tang, S. A. van Slyke; Appl. Phys. Lett. 51 (1987) 913). Damit war es möglich, gegenüber den anorganischen Materialien die Lumineszenzausbeute zu erhöhen und LEDs herzustellen, die blaues Licht emittieren. Die organischen Multi- bzw. Einfachschichten bilden Sandwichstrukturen zwischen einer transparenten Indium-Zinnoxid-Anode (ITO) und einer Metallkathode mit kleiner Austrittsarbeit wie z.B. Mg, Al oder Ca. Mit dem Aufbau von Mehrfachschichtsystemen bestehend aus Elektronentransportschicht, Emitterschicht und Lochtransportschicht konnten die Lumineszenzausbeute und deren Stabilität erhöht werden (A. Adachi, T. Tsutsui, S. Saito; Appl. Phys. Lett. 57 (1990) 531; Y. Hamada, C. Adachi, T. Tsutsui, S. Saito; Jpn. J. Appl. Phys. 31 (1992)1812. Bei der Verwendung von Monomeren werden die Schichten durch spezielle und damit kostenintensive Aufdampftechniken realisiert. Der Einsatz von Polymeren ermöglicht einen vereinfachten Deviceaufbau.

Konjugierte Polymere, die Halbleitereigenschaften mit Bandabständen zwischen 3,5 und 1,0 eV aufweisen, wie genannte Poly(p-phenylen-vinylen) (PPV) oder Poly(p-phenylen) (PP), werden in dem Device-Aufbau von LEDs als Emitter und oder Lochtransportschichten eingesetzt. Dabei ist es notwendig, organolösliche Materialien zu synthetisieren, um diese Polymere entsprechend durch einfach handhabbare Prozesse wie z. B. Spin-Coating- oder Dipping-Prozesse als Schichten aufzubringen. Ein Syntheseweg ist die Herstellung von löslichen Präpolymeren, die durch einen anschließenden Pyrolyseschritt im Vakuum in die entsprechenden unlöslichen konjugierten Polymere umgewandelt werden. Intensive Forschungsarbeiten zum PPV wurden unter anderem von Friend et al. (A. B. Holmes, D.D.C. Bradley, A. R. Brown, P.L. Burn, R. H. Friend; Synthetic Metals 55 -57 (1993) 4031, J. H. Burroughes, D. D. C.Bradley, R. H. Friend EP 0423 283 B1) sowie von Hörhold et al. (M. Helbig, H. H. Hörhold; Macromol. Chem 194 (1993) 1607; H. H. Hörhold et al. DE 19505416 A1) durchgeführt. Als besonders attraktiv erwiesen sich auch polymere und oligomere Thiophene. Sie gestatten die gezielte Einstellung der Wellenlänge des zu emittierenden Lichts durch Variation der am Heterocyclus gebundenen Substituenten (M. Granström, M. Berggren, und O. Inganäs: Science 267 (1995) 1479; E. G. J. Staring et. Al.; Adv. Mater. 6 (1994) 934), wobei jedoch die Quanteneffizienz unbefriedigend ist.

Lichtemittierende polymere LEDs, welche in Abhängigkeit von der angelegten Spannung im blauen, grünen und auch nahen IR-Bereich emittieren, wurden realisiert, indem z. B. Blends von zwei oder drei organischen Materialien hergestellt und daraus ein Schichtsystem aufgebaut wurde. Die ersten Arbeiten auf diesem Gebiet sind zurückzuführen auf Yoshino (Jpn. J. Appl. Phys., 32 (1993) L921), welcher Poly(di-octyloxyphenylen-vinylen) mit Aluminiumhydroxychinolat (Alq₃) zusammen mischte und ein Device aufbaute, welches die Farbe beim Erhöhen der Einsatzspannung kontinuierlich von rot-orange nach gelb-grün änderte. Heeger (J. Elec.Mat,20 (1991) 945) mischte Poly(2-cholesteryloxy-5-hexyldimethylsilyl-1,4-phenyl-vinylen) (CSPPV) mit 2-(4-Biphenyl-5-(4-tert.-butylphenyl-1,3,4-oxadiazol (PBD) und fertigte daraus ein Device. Er fand keinen Einfluß des PBDs auf die Form des Elektrolumineszenz-Spektrums. Inganäs (Appl. Phys. Lett. 68 (1996) 147) stellte PLEDs von Blends mit drei verschieden substituierten Polythiophen Derivaten und Polymethacrylat (PMMA) als Bindemittel vor, und realisierte eine weiße Emission bei einer sehr hohen Einsatzspannung von 20V. In dem US-Patent 6 127 693 wird die Anwendung eines Blends, welcher aus einem rot emittierenden alkoxysubstituierten Poly(phenylen-vinylen) und einem blau emittierenden Poly(p-phenylenvinylen) Copolymeren besteht und dessen Einsatz in einer organischen Leuchtdiode zu einer weißen Elektrolumineszenz führt, beschrieben.

Die Verwendung von Blends zur Herstellung von lichtemittierenden Dioden ist jedoch mit dem Nachteil behaftet, daß die eingesetzten Materialien untereinander mischbar sein müssen und keine Entmischungen (Phasentrennungen) auftreten dürfen. So können z.B. beim Einmischen von Monomeren in eine polymere Matrix Rekristallisationsprozesse auftreten, welche die Lebensdauer einer PLED begrenzen.

Der Erfindung liegt die Aufgabe zugrunde, polymere lichtemittierende Dioden bereitzustellen, welche die vorgenannten Nachteile nicht aufweisen.

Gegenstand der Erfindung ist eine polymere lichtemittierende Diode (PLED), umfassend
(i) eine transparente Elektrode als Anode,
(ii) eine Metallelektrode als Kathode,
(iii) ein organisches lichtemittierendes Zweischichtsystem und gegebenenfalls
(iv) mindestens eine Lochtransportschicht auf der Anode,
wobei das organische lichtemittierende Zweischichtsystem (iii) aus einer Schicht eines rot emittierenden polymeren Materials und einer Schicht eines blau emittierenden elektronentransportierenden polymeren Materials besteht, mit der Maßgabe, daß sich die Schicht des rot emittierenden Materials auf der transparenten Anode oder einer der gegebenenfalls vorhandenen Lochtransportschichten befindet.

Als Anoden werden vorzugsweise transparente Indium-Zinnoxid-Anoden (ITO) eingesetzt. Diese befinden sich zweckmäßigerweise auf einem Glassubstrat. Als Anode kann in der erfindungsgemäßen polymeren lichtemittierenden Diode auch ein transparentes, flexibles, leitfähiges Trägermaterial, wie beispielsweise PET (Polyethylenterephtalat), verwendet werden.

Zur Verringerung der Einsatzspannung wird zweckmäßigerweise zunächst eine löcherinjizierende Schicht auf der Basis von leitfähigen Polymeren, wie beispielsweise dotiertes Polyanilin oder BAYTRON^{®}, auf das ITO aufgebracht und anschließend darauf das oben definierte Zweischichtsystem aufgebaut.

Die rot-orange emittierenden Polymeren werden durch Spin-coating oder cast-on-Techniken auf den vorgenannten Anodenmaterialien abgeschieden. In der erfindungsgemäßen PLED werden als rot-orange emittierende Polymere vorzugsweise organolösliche alkoxysubstituierte Copolymere auf der Basis von Poly(phenylenvinylenen), welche an den Seitenketten reaktive Gruppen, wie z.B. Doppelbindungen, enthalten, verwendet.

Diese Copolymeren weisen die allgemeine Formel 1 auf 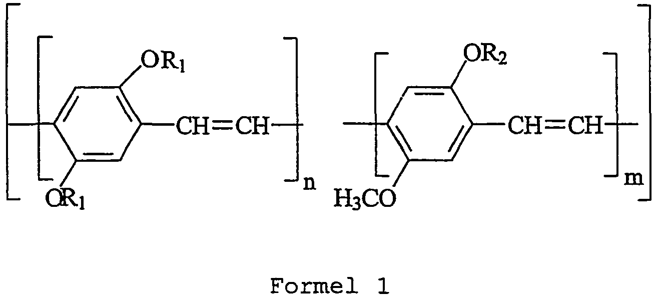 worin m für 50-97 mol% und n für 50-3 mol% stehen und R₁ für eine Alkylgruppe mit 3-20 Kohlenstoffatomen steht, die gegebenenfalls 1 bis 3 Doppelbindungen enthält und/oder endständige Si-Gruppen der Formel -Si(OR₁')₃ aufweist, worin R₁' eine Alkylgruppe mit 1 bis 3 Kohlenstoffatomen bedeutet, und R₂ für eine Alkylgruppe mit 6-20 Kohlenstoffatomen steht.

Die vorgenannten Alkylreste können verzweigt und/oder unverzweigt sein.

Auf der aus den vorgenannten rot-orange emittierenden Polymeren hergestellten Schicht wird eine zweite Schicht eines blau emittierenden und gleichzeitig elektronentransportierenden Polymeren aufgebracht.

Solche Polymere sind beispielsweise aromatische Poly(1,3,4-heterodiazole)(PODX) der allgemeinen Formel 2 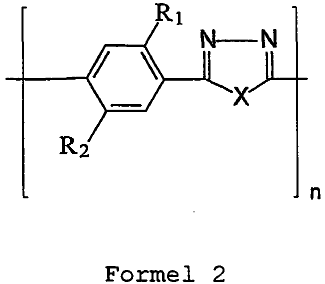 worin n für eine ganze Zahl von 10 bis 1000 steht und R₁ und R₂ gleich oder unterschiedlich sein können und jeweils für eine C₁-C₁₈-Alkyl-, C₁- C₁₈-Alkoxy-, Phenyl-, Phenoxy- oder Phenylthio-Gruppierung stehen und X für für S, O oder N-Phenyl steht.

Solche Poly(1,3,4-heterodiazole) sind in der DE 198 40 195 Cl beschrieben.

Weiterhin sind Polyfluorene der allgemeinen Formel 3 zu nennen, 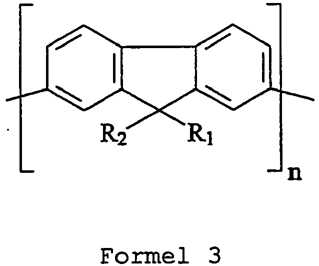 die in dem US-Patent 5 708 130 beschrieben sind.

Neben den vorgenannten Poly(1,3,4-heterodiazolen) und Polyfluorenen können auch Poly(p-Phenylene) der Formel 4 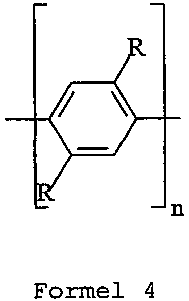 verwendet werden, die beispielsweise in Y. Yang, Q. Pei, A.J. Heeger, J. Appl. Phys. 79, 1996, 934 beschrieben sind.

Weiterhin können die in U. Scherf, K. Müllen, Macromolecules 25, 1992, 3546 beschriebenen Leiterpolymere eingesetzt werden.

Diese sind durch die folgende Formel 5 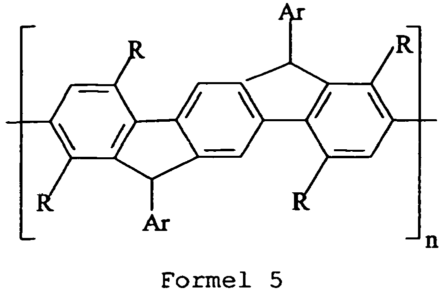 charakterisiert, worin Ar für einen Arylrest steht.

Die vorgenannten Polymere können durch Schichtprozesse, wie beispielsweise Spin-coating oder auch cast-on-Techniken, abgeschieden werden, wobei hier die Schichtdicken üblicherweise von 20 bis 200 nm reichen.

Die Erfindung betrifft weiterhin ein Verfahren zur Herstellung der voranstehend beschriebenen polymeren lichtemittierenden Dioden, welches die folgenden Stufen umfaßt:
(a) Aufbringen einer Lösung eines rot emittierenden Polymeren auf eine transparente Anode mittels Spin-coating oder cast-on-Techniken in einer Dicke von 30 bis 200 nm,
(b) Vernetzen der Polymerschicht mittels Temperaturbehandlung bei 180 bis 220°C oder Plasmabehandlung oder Bestrahlung mit UV-Licht mit einer Wellenlänge von 100 bis 300 nm,
(c) Auftragen einer Lösung eines blau emittierenden elektronentransportierenden Polymeren auf die gemäß Stufe (b) erhaltene Schicht durch Spin-coating oder cast-on-Techniken und anschließende Temperung zur Verdampfung des Lösungsmittels und
(d) Aufbringen einer Metallelektrode auf das gemäß Stufen (b) und (c) erhaltene Zweischichtsystem.

Die elektroneninjizierende Elektrode bzw. Kathode besteht beispielsweise aus Ca, Mg, Al, In oder Mg/Ag.

Das erfindungsgemäße Verfahren kann im Einzelfall auf die jeweiligen Gegebenheiten, wie z.B. die Polymerviskosität, die optimale Schichtdicke des Polymers im Device und ähnliches, angepaßt werden.

Im allgemeinen wird so vorgegangen, daß aus einem oder mehreren der vorgenannten Polymeren der allgemeinen Formel 1 eine Lösung hergestellt wird. Geeignete Lösungsmittel sind beispielsweise Toluol, Chloroform, Chlorbenzol, Xylol und Gemische daraus. Die Konzentration der Polymerlösung beträgt 3 bis 25 mg/ml.

Hieraus resultieren Lösungen mit einer Konzentration von 0,25 bis 1 Gew.-%.

Vorzugsweise werden Lösungen mit einer Konzentration von 0,5 bis 0,75 Gew.-% eingesetzt.

In Abhängigkeit von der Löslichkeit der jeweils eingesetzten Polymeren kann es auch von Vorteil sein, die Lösungen, die an sich bei Raumtemperatur hergestellt werden, bei 50 bis 70°C so lange zu rühren, bis keine Feststoffe mehr sichtbar sind. Gegebenenfalls erweist sich auch eine Behandlung im Ultraschallbad zur vollständigen Lösung der Polymeren als zweckmäßig.

Die Polymerlösungen werden anschließend auf ein als Anode fungierendes Substrat aufgebracht. Vorzugsweise wird ein mit Indium/Zinnoxid beschichtetes Glassubstrat (sogenannte Balzers) verwendet. Zur Anpassung der Injektionsbarrieren wird vor dem Aufbringen der Polymerlösungen noch eine polymere Zwischenschicht (beispielsweise BAYTRON^{®}, Bayer AG) aufgebracht.

Die Polymerlösungen werden zweckmäßigerweise vor ihrer Verwendung gereinigt, üblicherweise mittels eines Spritzenfilters. Anschließend erfolgt die Auftragung auf das Substrat mittels der vorher erwähnten Auftragungstechniken, wobei sich das Spin-coating als besonders zweckmäßig erweist.

Durch diese Technik kann die Schichtdicke im Bereich von 30 bis 200 nm variiert werden.

Anschließend erfolgt eine dreidimensionale Vernetzung der Polymerschicht mittels bekannter Methoden wie Temperung, Plasmabehandlung oder UV-Vernetzung. Hierdurch wird das Polymer unlöslich.

Die Temperung findet bei einer Temperatur von 180 bis 220°C über einen Zeitraum von etwa 4 Stunden statt.

Die Vernetzung mittels UV-Bestrahlung erfolgt bei einer Wellenlänge von 100 bis 300 nm.

Nach der Vernetzung kann problemlos die zweite polymere Schicht wiederum beispielsweise mittels Spin-coating aufgetragen werden. Hierbei geht man im Prinzip genauso vor wie bei der Herstellung der ersten Polymerschicht beschrieben.

Allerdings ist bei der Herstellung der zweiten Polymerschicht eine dreidimensionale Vernetzung nicht mehr erforderlich. Nach Aufbringen der Polymerlösung wird lediglich das Lösungsmittel verdampft, wobei sich die Temperatur nach dem Siedepunkt des zur Herstellung der Polymerlösung verwendeten Lösungsmittels bzw. Lösungsmittelgemischs richtet.

Nach Kontaktierung der Elektroden (beispielsweise ITO und Aluminium) und dem Anlegen einer negativen Spannung an die Kathode (Aluminiumelektrode) zeigen sich in Abhängigkeit von den eingesetzten Doppelschichtsystemen unterschiedliche Elektrolumineszenzspektren.

Mit dem vorgeschlagenen Zweischichtaufbau der erfindungsgemäßen polymeren lichtemittierenden Diode - wobei das Zweischichtsystem so in die Diode eingebaut ist, daß das rot emittierende Polymer (kleines Bandgap) auf die transparente Anode bzw. Lochtransportschicht aufgebracht wird und das Schichtsystem mit dem blau emittierenden Polymeren (großes Bandgap) und der Metallkathode vervollständigt wird - ist es möglich, nicht verträgliche Materialien miteinander in Kontakt zu bringen. Außerdem wird der blaue Emitter gleichzeitig als Elektronentransportschicht genutzte, so daß zusätzliche Schichten zur Verbesserung der Device-Eigenschaften, wie z.B. Einsatzspannung, nicht notwendig sind.

Die Erfindung wird durch die nachfolgenden Beispiele näher erläutert.

### Ausführungsbeispiele

### 1. Synthese der Ausgangsstoffe zur Herstellung der Alkenoxy- und Alkoxy- substituierten Poly(phenylenvinylen)-Copolymeren

### 1.1 Synthese der 2,5- Alkenoxy-substituierten 1,4-Bis(Chlormethyl)benzole

### 2,5-(Diallyloxy)diethylterephtalat:

2,5-Dihydroxydiethylterephtalat (10 g; 0.04 mol) und Allyliodid (46,3g : 0,275 mol) werden in 300 ml abs. Aceton gelöst. Nach der Zugabe von fein gepulvertem und frisch geglühtem K₂CO₃ (15g; 0,11 mol) und 3 Spatelspitzen KJ wird 48h unter Rückfluß und Stickstoff gekocht. Anschließend wird die Lösung möglichst heiß vom Kaliumcarbonat abfiltriert, die Lösung eingeengt und das Rohprodukt über eine Kieselgelsäule (Essigsäureethylester/ Hexan 1:1) filtriert. Nach dem erneuten Einengen wird ein weißer Feststoff erhalten, der anschließend durch Umkristallisieren aus Hexan gereinigt wurde.
Ausbeute: 10.51g = 80% , Fp.: 44°C
EA: C₁₉H₂₂O₆ (334,4 g/mol)
ber.: C 64,99%, H 6,63%, O 28,71%
gef . : C 64, 91%, H 6,63%
¹H-NMR (400 MHz, CDCl₃) : δ(ppm)= 7,45 (s,2H, arom.); 6,09 (m, 2H, C-H=); 5,52 (d.,2H, -CH₂=CH-), 5,33 (d.,2H, -CH₂=CH-), 4,63 (d, d, 4H, (O-CH₂-CH) ; 4,42 (q, 4H, -O-CH₂-CH₃), 1,45 (t, 6H, -CH₂-CH₃)

### 2,5-(Dicitronellyloxy)diethylerephtalat:

2,5-Dihydroxydiethylterephtalat (3g; 0.012 mol) und Citronellylbromid (25g : 0,114 mol) werden in 90 ml abs. Cyclohexanon gelöst. Nach der Zugabe von fein gepulvertem und frisch geglühtem K₂CO₃ (24,6g; 0,18 mol) und 1 Spatelspitze KJ wird 8h unter Rückfluß und Stickstoff gekocht. Anschließend wird die Lösung möglichst heiß vom Kaliumcarbonat abfiltriert, die Lösung eingeengt und das Rohprodukt über eine Kieselgelsäule (Essigsäureethylester/ Hexan 1:1) filtriert. Zurück bleibt ein gelbes Öl.
Ausbeute: 90%
EA: C₃₂H₅₀O₆ (530,3 g/mol)
ber.: C 72,42%, H 9,50%, O 18,09%
gef.: C72,84%, H 10,23%,
¹H-NMR (400 MHz, CDC13): δ(ppm)= 7,4 (s,2H, arom.); 6,09 (m, 2H, C-H=) ; 5,52 (d.,2H, -CH₂=CH-), 5,33 (d.,2H, -CH₂=CH-), 4,63 (d, d, 4H, (O-CH₂-CH) ; 4.42 (q,4H, -O-CH₂-CH₃), 1,45 (t, 6H, -CH₂-CH₃)

### 2,5-Bis(hydroxymethyl)-1,4-diallyloxy-benzol:

LiAlH₄ (7,09g;0,187 mol) wird in zirka 90ml abs. THF mit Argonüberlagerung vorgelegt und 2,5-(Diallyloxy)diethyl-terephtalat (12,5 g; 0,374 mol) gelöst in 60ml THF über einen Tropftrichter bei einer Temperatur von -65 °C langsam zugetropft. Das Reaktionsgemisch wird auf Raumtemperatur erwärmt und 15 h bei Raumtemperatur kräftig gerührt. Nach anschließenden 3 stündigen Rückflußkochen wird die Lösung abgekühlt und langsam zunächst mit wasserhaltigem THF , Wasser und 50% Schwefelsäure versetzt. Die Phasen werden durch Etherzugabe getrennt und die wäßrige Phase mit Ether ausgeschüttelt. Die organischen Phasen nochmals mit Wasser rückgeschüttelt, getrocknet über Natriumsulfat und schließlich eingeengt. Das erhaltene Rohprodukt wird in Essigsäureethylester umkristallisiert.
Ausbeute: 6,5g = 69%
EA: C₁₄H₁₈O₄ (250,3 g/mol)
ber.: C 67,20%, H 7,20%, O 25,57%
gef.: C 67,41%, H 7,28%
¹H-NMR (400 MHz, CDCl₃) : δ(ppm)= 6,9 (s,2H, arom.); 6,09 (m, 2H, C-H=); 5,52 (d.,2H, -CH₂=CH-), 5,33 (d.,2H, -CH2=CH-), 4,7 (s, 4H, (CH₂-OH) ; 4,62 (d, d, 4H,-O-CH₂-CH=), 2,4 (s, 2H, OH)

### 2,5-Bis(hydroxymethyl)-1,4-dicitronellyloxy-benzol:

LiAlH₄ (1,05 g, 28 mmol) wird in 34 ml abs. THF mit Argonüberlagerung vorgelegt und 2,5-(Dicitronellyl)diethylerephtalat (4,2 g; 7,9 mmol), gelöst in 6 ml abs. THF langsam bei Raumtemperatur zugetropft. Dabei wird die Reaktionsmischung kräftig gerührt und 6 h zum Rückfluß erhitzt. Anschließend wird noch über Nacht unter Argon weitergerührt. Nach dem Abkühlen wird vorsichtig überschüssiges LiAlH₄ durch wasserhaltige THF-Zugabe (50:50) zersetzt. Anschließend wird 50%ige Schwefelsäure zugegeben und 1 h nachgerührt. Die organische Lösung wird vom Feststoff abdekantiert und eingeengt. Der Rückstand in Ethylacetat aufgenommen und mehrmals mit Wasser gewaschen. Nach Trocknung über Na₂SO₄ wird das Lösungsmittel abgezogen und das entstehende Öl am Ölpumpenvakuum getrocknet.
Ausbeute: 3,2g = 90,5%
EA.: C₂₈H₄₆O₄ (446,28 g/mol)
ber. : C 75,35 %, H 10,31%
gef.: C 75,04%, H 10,66 %
¹H-NMR (400 MHz, CDCl₃) : δ (ppm) = 2,5 (s, 2H, O-H) ; 6,90 (s, 2H, ar-C-H); 5,15 (trip., 2H, -CH=C), 4,73 (s, 4H, CH₂OH) ; 4,05 (m, 4H, -O-CH₂-), 2,2-1,00 (m, 32H, -CH₂-, -CH₃)

### 2,5-Bis(Chlormethyl)-1,4-diallyloxy-benzol:

2,5-Bis(hydroxymethyl)-1,4-diallyl-benzol (2,22g; 8,87 mmol) werden in 32 ml abs. Essigsäureethylester gelöst und auf 0°C abgekühlt. Dazu werden unter Rühren (2,1g; 17,7 mmol) Thionylchlorid zugegeben und anschließend 3h bei 50°C gerührt. Der erkaltete Ansatz wird auf 100ml Eiswasser gegossen und solange mit Wasser ausgeschüttelt bis die wäßrige Phase neutral ist. Die organische Phase wird über Na₂SO₄ getrocknet und am Rotationsverdampfer eingeengt. Das erhaltene Rohprodukt wird in n-Hexan umkristallisiert.
Ausbeute: 1,85g = 72%, Fp.: 79°C
EA: C₁₄H₁₆Cl₂O₂ (287,2 g/mol)
ber.: C 58,55%, H 5,615%, O 11,13%, Cl 24,72%
gef.: C 58,61%, H 5,90%
¹H-NMR (400 MHz, CDCl₃) : δ (ppm) = 6,98 (s,2H, arom.); 6,1 (m, 2H, C-H=); 5,52 (d.,2H, -CH₂=CH-), 5,33 (d.,2H, -CH₂=CH-), 4,7 (s, 4H, (CH₂-Cl) ; 4,62 (d, d, 4H, -O-CH₂-CH=)

### 2,5-Bis(chlormethyl)-1,4-dicitronellyloxy-benzol:

Unter Stickstoff wurde 2,5-Bis(hydroxymethyl)-1,4-dicitronellyl-benzol (3,2g, 7,2 mmol) vorgelegt und Thionylchlorid (1 ml, 14,4 mmol) vorsichtig zugegeben. Der Ansatz rührte 3h bei 50°C und anschließend noch über Nacht bei Raumtemperatur. Der Ansatz wurde vorsichtig am nächsten Tag auf Eiswasser gegossen und mit Ethylacatat extrahiert und schließlich wurde die organische Phase noch neutral gewaschen. Nach dem Trocknen über Na₂SO₄ wurde das Ethylacetat abgezogen und das Rohprodukt durch Säulenchromatographie mit Hexan: Ethylacetat (10 :1) abgetrennt.
Ausbeute: 1,6g = 46% , Fp.: 25°C
EA: C₂₈H₄₆O₂Cl₂ (483,28 g/mol)
ber. : C 69,58 %, H 9,17%
gef, : C 67,04% , H 9,25 %
¹H NMR (400 MHz, CDCl₃) : δ (ppm) = 6,90 (s, 2H, ar-C-H); 5,15 (trip., 2H, -CH=C), 4,65 (s, 4H, CH₂Cl); 4,05 (m,4H,-O-CH₂-), 2,2 -1,00 (m, 32H, -CH₂-, -CH₃)

### 1.2 Synthese der 2,5- Alkoxy-substituierten 1,4-Bis (Clormethyl)benzole

Die Synthese des 2-Methoxy-5-(2-ethylhexyl)-oxy-1,4-bis-(chlormethyl) benzols erfolgte analog des von B.R. Hsieh, Y. Yu, A. C. van Laeken und H. Lee in Macromolecules 30, (1997), 8094 beschriebenen Syntheseweges.

### 2. Synthese und Charakterisierung der Polymeren

Copolymer aus 25 mol% 2,5-Bis(Chlormethyl)-1,4-diallyloxy-benzol und 75 mol% 2-Methoxy-5-(2-ethylhexyl)-oxy-1,4-bis(chlormethyl) benzol

### (Polymer Al)

Copolymer aus 10 mol% 2,5-Bis(Chlormethyl)-1,4-diallyloxy-benzol und 90 mol% 2-Methoxy-5-(2-ethylhexyl)-oxy-1,4-bis(chlormethyl) benzol

### (Polymer A2)

Copolymer aus 25 mol% 2,5-Bis(Chlormethyl)-1,4-dicitronellyloxy-benzol und 75 mol% 2-Methoxy-5-(2-ethylhexyl)-oxy-1,4-bis(chlormethyl) benzol

### (Polymer A3)

Vorschrift für die Polymerisationen analog der DE 19748814 Al (Covion, H. Spreitzer, W. Kreuder, H. Schenk, Y. Nu)

### Allgemeines Syntheseschema

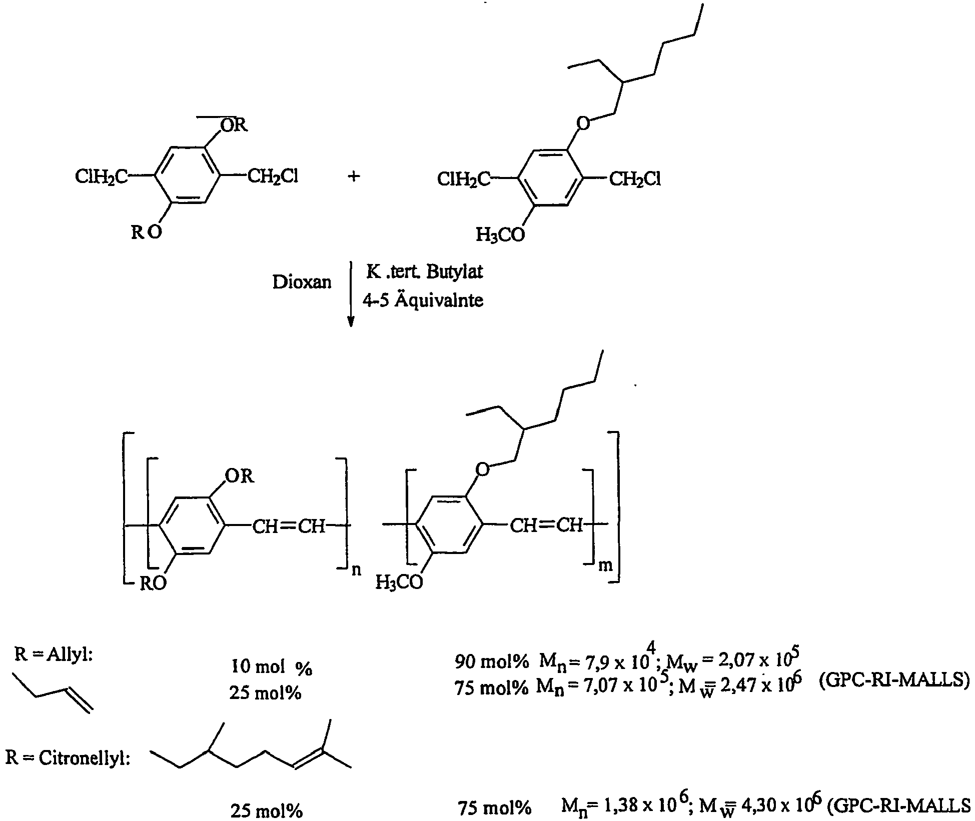

### 2.1 Herstellung von Copoly(2-methoxy-5-(2-ethylhexyloxy)-p-phenylenvinylen) (2,5-diallyoxy-p-phenylenvinylen) (Polymer A1, Polymer A2)

In einem ausgeheizten Sulfierkolben mit mechanischen Teflonrührer, Thermometer und Tropftrichter werden 450 ml trockenes Dioxan vorgelegt, durch 30 minütiges Durchleiten von Stickstoff entgast und dann unter Rühren auf 95 °C erhitzt. Danach werden entweder 0,2 g (10 mol%, 0,7 mmol) (Polymer A2) oder 0,502 g (25 mol%, 1,75 mmol) (Polymer A1) 2,5-Bis(Chlormethyl)-1,4-diallyloxy-benzol und als andere Komponente entweder 2,09 g (90mol%, 6,3 mmol) (Polymer A2) oder 1,75g (75 mol%, 5,25 mmol) (Polymer A1) 2-Methoxy-5-(2-ethylhexyl)-oxy-1,4-bis(chlormethyl) benzol, gelöst in 10 ml Dioxan zugegeben. Anschließend werden zunächst 20 ml einer Lösung von 3,93 g (0,035 mol) K.tert.-Butylat in 41 ml Dioxan innerhalb von 5 Minuten zugetropft. Nach weiteren 5 Minuten wird der Rest an K.tert.-Butylatlösung zugegeben. Die Reaktionslösung wird weitere 2h kräftig bei 95 °C gerührt, abgekühlt auf 50°C und ein Gemisch bestehend aus 2,5 ml Dioxan und 2,5 ml konz. HC1 zugesetzt und das Polymer in zirka 1,51 Wasser ausgefällt. Das ausgefallene Polymer wird abgesaugt, mehrmals mit Wasser und anschließend mit Methanol gewaschen und getrocknet. Als Rohprodukte werden isoliert 1,64 g Polymer A1 und 1,6 g Polymer A2. Die Polymeren werden durch zweimaliges Umfällen gereinigt. Dazu werden diese in zirka 200 ml THF gelöst unter Erwärmen und in 600 ml Methanol ausgefällt. Nach Trocknen bei 50°C im Vakuum über Nacht werden noch 1,05 g (61%) Polymer A1 und 0,85 g (49%) Polymer A2 erhalten.

### Polymer A1

¹H NMR (400 MHz, CDCl₃): δ (ppm) = 6,8 -7,7 ppm(m, Hₐᵣₒₘ, H_{olefin}) ; 5,8- 6,5 (m, CH₂-CH-) ; 4, 6-5, 7 (m, =CH₂-) ; 3,0 - 4,2 (m, OCH₃, OCH₂-) ; 0,8 -2 (m, alkyl)
GPC-RI-MALLS M_{w} = 2,47 x 10⁶ g/mol; Mₙ = 7,07 x 10⁵ g/mol

### Polymer A2

¹H NMR(400 MHz, CDCl₃): δ(ppm) = 6,8 -7,7 ppm(m, Hₐᵣₒₘ, H_{olefin}) ; 6,4- 6,6 (m, CH₂-CH-) ; 4,8-5,1 (m, =CH₂-); 3, 6 - 4,3 (m, OCH₃, OCH₂-); 0,8 -2 (m, alkyl)
GPC-RI-MALLS M_{w} = 2,07 x 10⁵ g/mol; Mₙ = 7,90 x 10⁴ g/mol

### 2.2 Herstellung von Copoly(2-methoxy-5-(2-ethylhexyloxy)-p-phenylenvinylen) (2,5-dicitronellyloxy-p-phenylenvinylen) Polymer A3

In einem ausgeheizten Sulfierkolben mit mechanischen Teflonrührer, Thermometer und Tropftrichter werden 450 ml trockenes Dioxan vorgelegt, durch 30 minütiges Durchleiten von Stickstoff entgast und dann unter Rühren auf 95 °C erhitzt. Danach werden 0,8 g (30 mol%, 1,65mol) 2,5-Bis(Chlormethyl)-1,4-dicitronellyloxy-benzol und als andere Komponente 1,12g (70 mol%, 3,36 mmol) 2-Methoxy-5-(2-ethylhexyl)-oxy-1,4-bis(chlormethyl) benzol, gelöst in 10 ml Dioxan, zugegeben. Anschließend werden zunächst 12 ml einer Lösung von 2,81 g (0,025 mol) K.tert.-Butylat, gelöst in 25 ml Dioxan, innerhalb von 5 Minuten zugetropft. Nach weiteren 5 Minuten wurde der Rest an K.tert.-Butylatlösung zugegeben. Die Reaktionslösung wird weitere 2h kräftig bei 95 °C gerührt, abgekühlt auf 50°C und ein Gemisch bestehend aus 2 ml Dioxan und 2ml Essigsäure zugesetzt und das Polymer in zirka 1,5 1 Wasser ausgefällt. Das ausgefallene Polymer wird abgesaugt, mehrmals mit Wasser und anschließend mit Methanol gewaschen und getrocknet. Als Rohprodukt werden 0,91 g (Polymer A3) isoliert. Das Polymer wird durch zweimaliges Umfällen gereinigt. Dazu wird dieses unter Erwärmen in zirka 200ml THF gelöst und in 600 ml Methanol ausgefällt. Nach Trocknen bei 50°C im Vakuum über Nacht werden noch 0,45 g (30%) Polymer A3 erhalten.

### Polymer A3

¹H NMR(400 MHz, CDCl₃) δ (ppm) = 6,6 -7,9 ppm (m, Hₐᵣₒₘ, H_{olefin}); 5,0- 5,3 (s, CH=C-Kette); 4,6-5,7 (m, =CH₂-) ; 3,6 - 4,4 (m, OCH₃, OCH₂-); 0,8 -2,2 (m, alkyl)
GPC-RI-MALLS M_{w} = 4,30 x 10⁶ g/mol; Mₙ = 1,38 x 10⁶ g/mol

### 3. Herstellung und Charakterisierung von PLEDs

Die Herstellung von den PLEDs erfolgt nach dem im folgenden skizzierten allgemeinen Verfahren. Dieses muß natürlich im Einzelfall auf die jeweiligen Gegebenheiten (z.B. Polymerviskosität, optimale Schichtdicke des Polymers im Device u.ä.) angepaßt werden. Die im nachfolgenden beschriebenen PLEDs sind jeweils Doppelschichtsysteme, d.h. Substrat / ITO / Polymer A1-A3 mit einem anschließenden Vernetzungsschritt / Polymer PODX (Elektronenleiter u. blauer Emitter) / Kathode

Von dem jeweiligen Polymer A1 - A3 wird in der Regel eine Lösung mit einer Konzentration von 3 - 25 mg/ml in beispielsweise Toluol, Chloroform, Chlorbenzol, Xylol bei Raumtemperatur bereitet. Zur Herstellung des Elektrolumineszenzdevices 1 wird das Polymer A1 in Toluol gelöst und Lösungen im Konzentrationsbereich von 0,25% bis 1% hergestellt. Der bevorzugte Bereich liegt dabei zwischen 0,5% und 0,75%. Je nach Polymer kann es auch von Vorteil sein, die Lösungen für einige Zeit bei 50 - 70°C zu rühren oder im Ultraschallbad zu behandeln.

Vor dem spin-coating der Polymerlösungen auf mit einer ITO beschichteten Glassubstraten (Balzers) von ca. 25 cm² wird eine polymere Zwischenschicht (BAYTRON^{®}, Bayer AG) zur Anpassung der Injektionsbarrieren aufgebracht.

Die Polymerlösungen werden durch ein 1µm-Spritzenfilter vor dem spin-coating gereinigt. Zunächst wird eine rot-orange emittierende polymere Schicht (A1-A3) mit einer Dicke von 110 nm aufgebracht. Die Schichtdicken können mit Hilfe der spin-coating Parameter zwischen 30 - 200 nm variiert werden.

Die anschließende Vernetzung der Schichten erfolgt dann entweder thermisch (im Temperaturbereich zwischen 180 - 220 °C) oder durch eine Plasmabehandlung oder auch mittels UV-Bestrahlung (100-300 nm).

Danach kann problemlos die zweite polymere Schicht (PODX) durch spin-coating aufgetragen werden.

Nach Kontaktierung der Elektroden (ITO und Aluminium) und dem Anlegen einer negativen Spannung an die Aluminiumelektrode zeigen sich in Abhängigkeit von den unterschiedliche Elektrolumineszenzspektren.

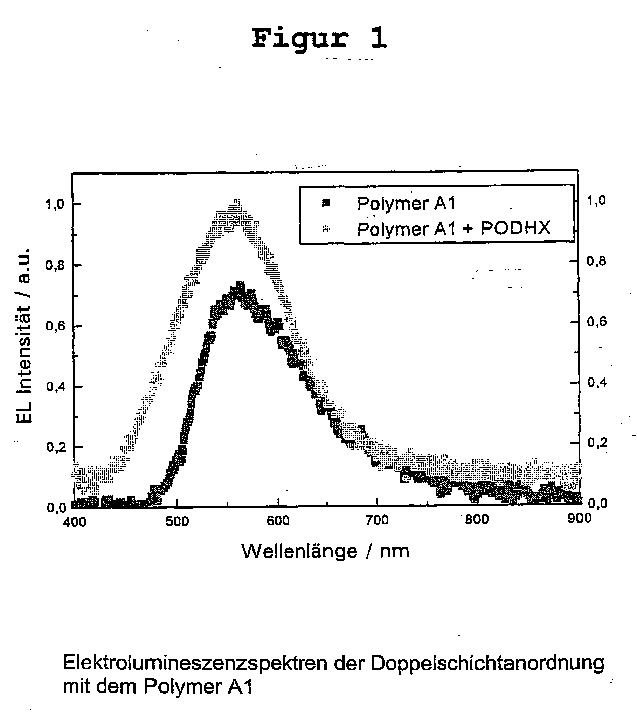

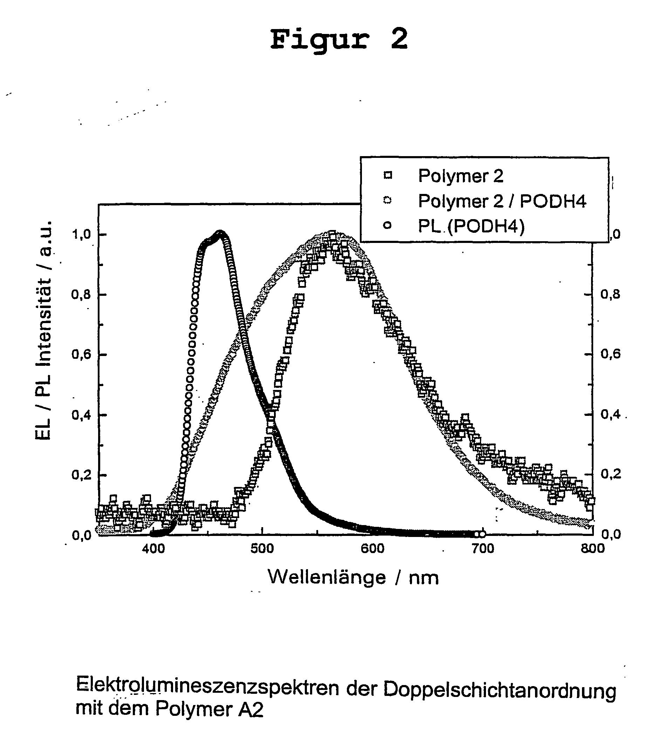

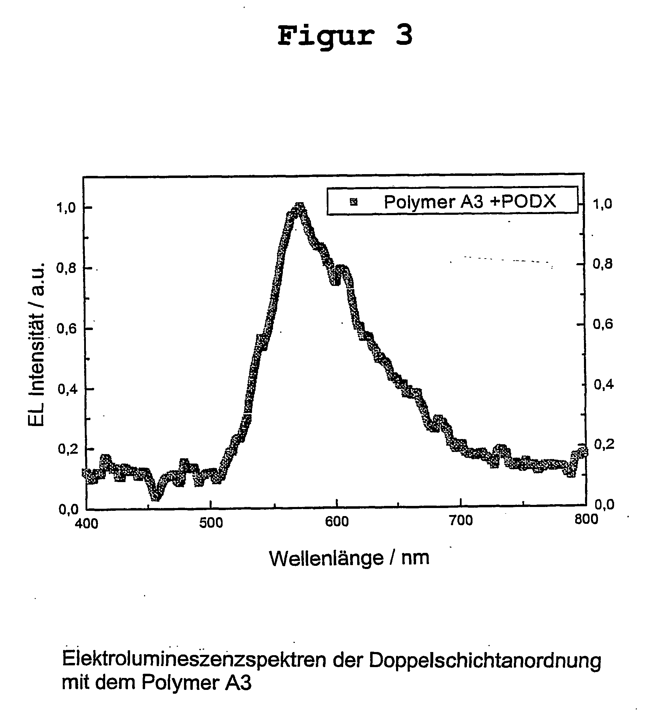

Folgende Varianten sind in den nachfolgenden Ausführungsbeispielen zum Einsatz gekommen:
**(i) Orange-rot emittierndes Polymermaterial A1 (Tempe**rung bei 220 °C) mit einem blauen Emitter und Elektronenleiter (Polymer A1 / PODX) (vgl. Figur 1)
(ii) Orange-rot emittierndes Polymermaterial A2 (Wasserstoffplasma-Behandlung) mit einem blauen Emitter und Elektronenleiter (Polymer A2 / PODX) (vgl. Figur 2)
(iii) Orange-rot emittierndes Polymermaterial A3 (Temperung bei 220°C) mit einem blauen Emitter und Elektronenleiter (Polymer A3 / PODX) (vgl. Figur 3) Helligkeit in Abhängigkeit von der angelegten Spannung einer Doppelschichtanordnung mit dem Polymer A3

Die Figuren 1 bis 3 zeigen Elektrolumineszenzspektren der Doppelschichtanordnungen mit den Polymeren A1, A2 und A3.

Die Figur 2 zeigt weiterhin die Photolumineszenz-Intensität.

Die beschriebenen PLEDs sind jeweils Doppelschichtsysteme, die eine weiße Emission zeigen, welche an der Breitbandigkeit der Elektrolumineszenzspektren zu erkennen ist. Die Einsatzspannungen liegen in Abhängigkeit von den Polymerschichtdicken zwischen 2,5 - 9 V, die Helligkeiten betragen 400 cd/m² bei 7 V.

## Patentansprüche

1. Polymere lichtemittierende Diode (PLED), umfassend
(i) eine transparente Elektrode als Anode,
(ii) eine Metallelektrode als Kathode,
(iii) ein organisches lichtemittierendes Zweischichtsystem und gegebenenfalls
(iv) mindestens eine Lochtransportschicht auf der Anode,
wobei das organische lichtemittierende Zweischichtsystem (iii) aus einer Schicht eines rot emittierenden polymeren Materials und einer Schicht eines blau emittierenden elektronentransportierenden polymeren Materials besteht, mit der Maßgabe, daß sich die Schicht des rot emittierenden Materials auf der transparenten Anode oder einer der gegebenenfalls vorhandenen Lochtransportschichten befindet.

2. Polymere lichtemittierende Diode nach Anspruch 1, **dadurch gekennzeichnet, daß** die Schicht des rot emittierenden polymeren Materials aus einem organo-löslichen alkoxysubstituierten Copolymeren auf Poly(phenylenvinylen)-Basis der allgemeinen Formel 1 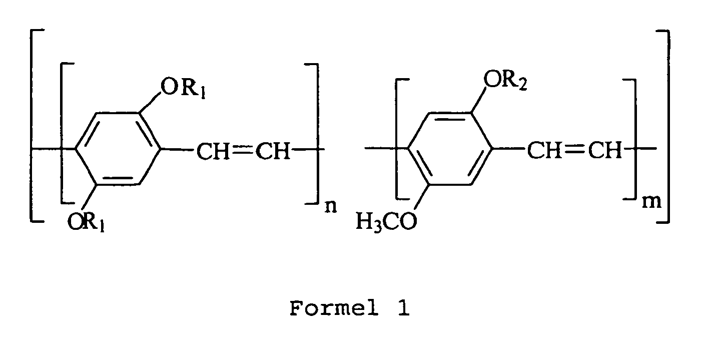 hergestellt worden ist, worin m für 50-97 mol% und n für 50-3 mol% stehen und R₁ für eine Alkylgruppe mit 3-20 Kohlenstoffatomen steht, die gegebenenfalls 1 bis 3 Doppelbindungen enthält und/oder endständige Si-Gruppen der Formel -Si(OR₁')₃ aufweist, worin R₁' eine Alkylgruppe mit 1 bis 3 Kohlenstoffatomen bedeutet, und R₂ für eine Alkylgruppe mit 6-20 Kohlenstoffatomen steht.

3. Polymere lichtemittierende Diode nach Anspruch 2, **dadurch gekennzeichnet,**
**dass** R₁ für Allyl, Citronellyl oder Geranoyl steht.

4. Polymere lichtemittierende Diode nach einem der Ansprüche 1 bis 3, **dadurch gekennzeichnet,**
**dass** die Schicht des rot emittierenden polymeren Materials eine Dicke von 50 bis 200 nm aufweist.

5. Polymere lichtemittierende Diode nach Anspruch 1, **dadurch gekennzeichnet,**
**dass** es ein Substrat aufweist, welches Indium-Zinnoxid (ITO) auf Glas ist, das mit einem leitfähigen Polymeren zur Erzeugung einer löcherinjizierenden Schicht beschichtet worden ist.

6. Polymere lichtemittierende Diode nach einem der Ansprüche 1 bis 5, **dadurch gekennzeichnet,**
**dass** die Schicht eines blau emittierenden elektronentransportierenden polymeren Materials aus Polymeren der allgemeinen Formel 2 hergestellt worden ist: 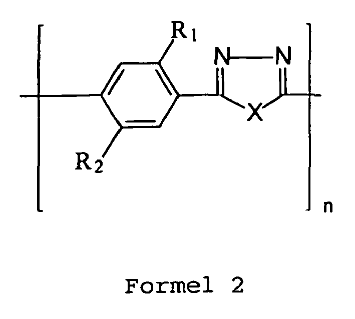 worin n für eine ganze Zahl von 1 bis 1000 steht und R₁ und R₂ gleich oder unterschiedlich sein können und jeweils für eine C₁-C₁₈- Alkyl-, C₁-C₁₈- Alkoxy-, Phenyl-, Phenoxy- oder Phenylthio-Gruppierung stehen und X für S, O oder N-Phenyl steht.

7. Verfahren zur Herstellung einer polymeren lichtemittierenden Diode nach Anspruch 1,
**gekennzeichnet durch** die folgenden Stufen:
(a) Aufbringen einer Lösung eines rot emittierenden Polymers auf eine transparente Anode mittels Spin-coating oder cast-on-Techniken in einer Dicke von 30 bis 200 nm,
(b) Vernetzen der Polymerschicht mittels Temperaturbehandlung bei 180 bis 220°C oder Plasmabehandlung oder Bestrahlung mit UV-Licht mit einer Wellenlänge von 100 bis 300 nm,
(c) Auftragen einer Lösung eines blau emittierenden elektronentransportierenden Polymers auf die gemäß Stufe (b) erhaltene Schicht **durch** Spin-coating oder cast-on-Techniken und anschließende Temperung zur verdampfung des Lösungsmittels und
(d) Aufbringen einer Metallelektrode auf das gemäß Stufen (b) und (c) erhaltene Zweischichtsystem.

8. Verfahren nach Anspruch 7,
**dadurch gekennzeichnet, dass** die in Stufe (a) verwendete Polymerlösung eine Konzentration von 0,25 bis 1 Gew.-%, vorzugsweise 0,5 bis 0,75 Gew.-%, aufweist, und die Polymerlösung eine Lösung von Polymeren der allgemeinen Formel 1 nach Anspruch 2 ist.

9. Verfahren nach Anspruch 8,
**dadurch gekennzeichnet, dass** die Polymerlösung vor ihrer Verwendung im Ultraschallbad behandelt oder bei einer Temperatur von 50 bis 70°C gerührt worden ist.

10. Verfahren nach Anspruch 7,
**dadurch gekennzeichnet, dass** vor dem Aufbringen der Polymerlösung auf die Anode dieses mit einer polymeren Zwischenschicht zur Anpassung der Injektionsbarrieren versehen worden ist.

## Claims

1. A polymeric light-emitting diode (PLED), comprising
(i) a transparent electrode as the anode
(ii) a metal electrode as the cathode,
(iii) an organic light-emitting two-layer system and, optionally,
(iv) at least one hole transport layer on the anode;
wherein the organic light-emitting two-layer system (iii) consists of a layer of a red-emitting polymeric material and a layer of a blue-emitting electron transporting polymeric material with the proviso that the layer of the red-emitting material is located on the transparent anode or on one of the hole transport layers optionally present.

2. The polymeric light-emitting diode of claim 1, **characterised in that** the layer of the red-emitting polymeric material has been prepared from an organo-soluble alkoxy-substituted copolymer on a poly(phenylene vinylene) basis of the general formula 1 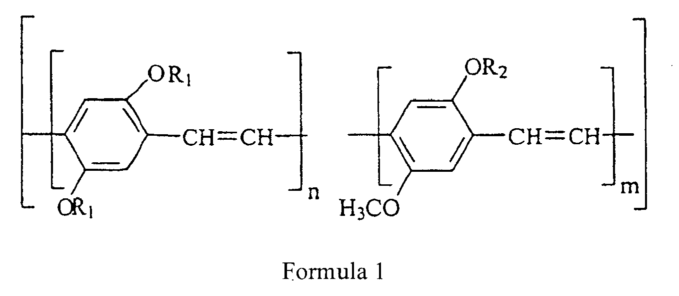 wherein m represents 50 to 97 mol-% and n represents 50 to 3 mol-% and R₁ represents an alkyl group having 3 to 20 carbon atoms which, optionally, contains 1 to 3 double bonds and/or terminal Si groups of the formula -Si(OR₁')₃ wherein R₁' represents an alkyl group having 1 to 3 carbon atoms and R₂ represents an alkyl group having 6 to 20 carbon atoms.

3. The polymeric light-emitting diode of claim 2, **characterised in that** R₁ represents allyl, citronellyl or geranoyl.

4. The polymeric light-emitting diode according to any of the claims 1 to 3, **characterised in that** the layer of the red-emitting polymeric material has a thickness of 50 to 200 nm.

5. The polymeric light-emitting diode of claim 1, **characterised in that** it has a substrate which is indium tin oxide (ITO) on glass coated with a conductive polymer to generate a hole-injecting layer.

6. The polymeric light-emitting diode according to any of the claims 1 to 5, **characterised in that** the layer of a blue-emitting electron-transporting polymeric material is prepared from polymers of the general formula 2: 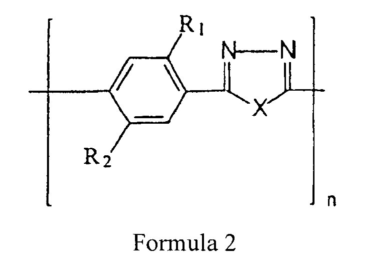 wherein n represents an integer from 1 to 1,000 and R₁ and R₂ may be the same or different and each represents a C₁-C₁₈ alkyl, C₁-C₁₈ alkoxy, phenyl, phenoxy or phenylthio group and X represents S, O or N-phenyl.

7. A process for preparing a polymeric light-emitting diode according to claim 1, **characterised by** the following steps:
(a) applying a solution of a red-emitting polymer onto a transparent anode in a thickness of 30 to 200 nm by means of spin coating or cast-on techniques,
(b) cross-linking the polymer layer by means of a high-temperature treatment at 180 to 220°C or plasma treatment or irradiation with UV light at a wavelength of 100 to 300 nm,
(c) applying a solution of a blue-emitting electron-transporting polymer onto the layer obtained according to step (b) by spin coating or cast-on techniques and subsequent tempering to evaporate the solvent, and
(d) applying a metal electrode onto the two-layer system obtained according to steps (b) and (c).

8. The process of claim 7, **characterised in that** the polymer solution used in step (a) has a concentration of 0.25 to 1 wt.-%, preferably 0.5 to 0.75 wt.-%, and the polymer solution is a solution of polymers of the general formula 1 according to claim 2.

9. The process of claim 8, **characterised in that** the polymer solution has been treated in a ultrasonic bath or stirred at 50 to 70°C before use.

10. The process of claim 7, **characterised in that** the anode has been provided with a polymeric interlayer before application of the polymer solution in order to adapt the injection barriers.

## Revendications

1. Diode polymère électroluminescente (PLED), comprenant
(i) une électrode transparente en tant qu'anode,
(ii) une électrode métallique en tant que cathode,
(iii) un système à deux couches organique électroluminescent et éventuellement
(iv) au moins une couche de transport de trous sur l'anode,
sachant que le système à deux couches organique électroluminescent (iii) est constitué d'une couche d'un matériau polymère émettant dans le rouge et d'une couche d'un matériau polymère de transport d'électrons, émettant dans le bleu, sous réserve que la couche du matériau émettant dans le rouge se trouve sur l'anode transparente ou sur l'une des couches de transport de trous éventuellement présentes.

2. Diode polymère électroluminescente selon la revendication 1, **caractérisée en ce que** la couche du matériau polymère émettant dans le rouge a été fabriquée à partir d'un copolymère organosoluble substitué par alcoxy à base de polyphénylène-vinylène de la formule générale 1 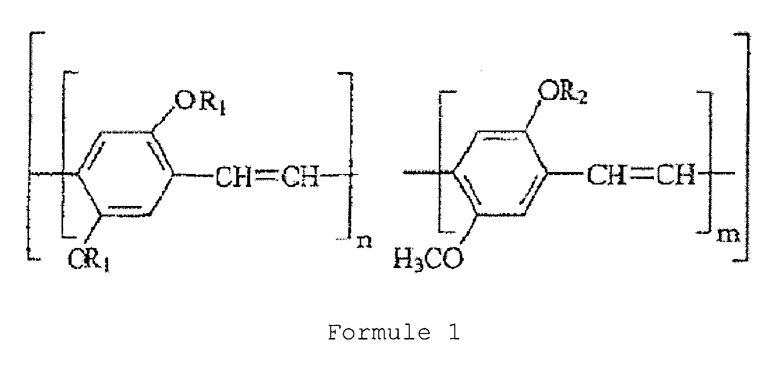 dans laquelle m représente 50 à 97 % en moles et n représente 3-50 % en moles et R₁ représente un groupe alkyle comportant 3 à 20 atomes de carbone, lequel groupe alkyle contient éventuellement 1 à 3 doubles liaisons et/ou présente des groupes terminaux Si de la formule -Si(OR₁')₃, dans laquelle R₁' représente un groupe alkyle comportant 1 à 3 atomes de carbone et R₂ représente un groupe alkyle comportant 6 à 20 atomes de carbone.

3. Diode polymère électroluminescente selon la revendication 2, **caractérisée en ce**
**que** R₁ représente de l'allyle, de la citronellyle ou du géraniol.

4. Diode polymère électroluminescente selon l'une quelconque des revendications 1 à 3, **caractérisée en ce**
**que** la couche du matériau polymère émettant dans le rouge présente une épaisseur allant de 50 à 200 nm.

5. Diode polymère électroluminescente selon la revendication 1, **caractérisée en ce**
**qu'**elle présente un substrat qui est de l'oxyde de zinc-indium (ITO) sur du verre, lequel a été enduit d'un polymère conducteur afin de produire une couche injectrice de trous.

6. Diode polymère électroluminescente selon l'une quelconque des revendications 1 à 5, **caractérisée en ce**
**que** la couche d'un matériau polymère de transport d'électrons émettant dans le bleu a été fabriquée à partir de polymères de la formule générale 2 : 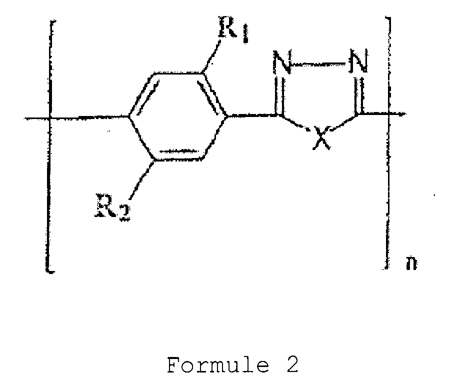 dans laquelle n représente un nombre entier allant de 1 à 1000 et R₁ et R₂ peuvent être identiques ou différents et représentent respectivement des groupements alkyles en C₁-C₁₈, des groupements alcoxy en C₁-C₁₈, des groupements phényle, des groupements phénoxy ou des groupements phénylthio et X représente du S, du O ou du N-phényle.

7. Procédé servant à fabriquer une diode polymère électroluminescente selon la revendication 1,
**caractérisé par** les étapes suivantes consistant à :
(a) appliquer une solution d'un polymère émettant dans le rouge sur une anode transparente au moyen de techniques d'enduction centrifuge ou de coulée en une épaisseur allant de 30 à 200 mm,
(b) réticuler la couche polymère au moyen d'un traitement thermique à des températures allant de 180 °C à 220 °C ou au moyen d'un traitement plasma ou d'une exposition à la lumière ultraviolette présentant une longueur d'ondes comprise entre 100 et 300 nm,
(c) appliquer une solution d'un polymère de transport d'électrons émettant dans le bleu sur la couche obtenue selon l'étape (b) par des techniques d'enduction centrifuge ou de coulée et par une trempe consécutive servant à évaporer le solvant et
(d) placer une électrode métallique sur le système à deux couches obtenu selon les étapes (b) et (c).

8. Procédé selon la revendication 7,
**caractérisé en ce que** la solution polymère utilisée à l'étape (a) présente une concentration comprise entre 0,25 et 1 % en poids, de préférence comprise entre 0,5 et 0,75 % en poids, et **en ce que** la solution polymère est une solution de polymères de la formule générale 1 selon la revendication 2.

9. Procédé selon la revendication 8,
**caractérisé en ce que** la solution polymère est traitée avant son utilisation dans un bain d'ultrasons ou a été mélangée à une température comprise entre 50 et 70 °C.

10. Procédé selon la revendication 7,
**caractérisé en ce qu'**avant l'application de la coche polymère sur l'anode, ladite anode a été pourvue d'une couche intermédiaire polymère servant à adapter les barrières d'injection.
